# FASCICULE DE BREVET EUROPEEN

(11) **EP 3 650 958 B1**
(45) Date de publication et mention de la délivrance du brevet: **11.08.2021**
(21) Numéro de dépôt: 18204700.1
(22) Date de dépôt: 06.11.2018
(51) Int. Cl.: G04G 17/04, G04G 17/06

(54) **OBJET MUNI D'UN DISPOSITIF D'AFFICHAGE ELECTROOPTIQUE**
GEGENSTAND, DER MIT EINER ELEKTROOPTISCHEN ANZEIGEVORRICHTUNG AUSGESTATTET IST
OBJECT PROVIDED WITH AN ELECTRO-OPTICAL DISPLAY DEVICE

(43) Date de publication de la demande: 13.05.2020
(73) Titulaire: The Swatch Group Research and Development Ltd, 2074 Marin (CH)
(72) Inventeur: Schindler, Axel, 3232 Ins (CH); Hamm, Alain, 2000 Neuchâtel (CH)
(74) Mandataire: ICB SA

(56) Documents cités:
- EP-A1- 2 784 607
- US-A1- 2015 029 829
- US-A1- 2017 168 463

## Description

### Domaine technique de l'invention

La présente invention concerne un objet muni d'un affichage électrooptique. Plus précisément, l'invention concerne un objet tel qu'une pièce d'horlogerie ou un téléphone intelligent qui comprend un cadre délimitant une ouverture dans laquelle est agencé le dispositif d'affichage électrooptique.

### Arrière-plan technologique de l'invention

La présente invention concerne le domaine des dispositifs d'affichage électrooptiques. Ces dispositifs d'affichage électrooptiques comprennent classiquement au moins un substrat qui sert de support à un élément optiquement actif disposé entre au moins une électrode et une contre-électrode correspondante et dont les propriétés optiques peuvent être modifiées par application d'une tension ou d'un courant électrique. Parmi les dispositifs d'affichage qui répondent à cette définition, on peut notamment citer les dispositifs d'affichage à cristal liquide (encore connus sous leur dénomination anglo-saxonne Liquid Crystal Display devices ou LCD devices), les cellules à diodes organiques électroluminescentes (également connues sous leur dénomination anglo-saxonne Organic Light Emitting Diode devices ou OLED devices), les dispositifs d'affichage électrochromiques ou bien encore les dispositifs d'affichage électrophorétiques.

A titre d'exemple illustratif seulement, on peut envisager le cas d'un dispositif d'affichage à cristal liquide par exemple du type nématique en hélice (Twisted Nematic ou TN en terminologie anglo-saxonne) qui comprend un substrat avant qui s'étend parallèlement à et à distance d'un substrat arrière. Ces substrats avant et arrière sont réunis entre eux au moyen d'un cadre de scellement qui délimite une enceinte étanche dans laquelle est confiné le cristal liquide. Des électrodes et des contre-électrodes sont structurées sur les faces en regard des substrats avant et arrière. Par application d'une tension électrique entre une électrode et une contre-électrode déterminées, il est possible de modifier les propriétés optiques du cristal liquide au point de croisement entre cette électrode et cette contre-électrode.

Pour assurer le bon fonctionnement d'un dispositif d'affichage à cristal liquide, il convient de relier les électrodes et les contres-électrodes de ce dernier à un dispositif électronique d'alimentation et de commande situé au moins pour partie à l'extérieur du dispositif d'affichage. A cette fin, l'un des deux substrats, habituellement le substrat arrière, est prévu plus grand que le substrat avant et l'on met à profit ce surcroît de surface pour prolonger par des pistes électriquement conductrices les contre-électrodes portées par le substrat arrière hors du cadre de scellement du dispositif d'affichage. De même, les électrodes portées par le substrat avant sont reportées sur le substrat arrière par exemple au moyen de billes conductrices de l'électricité dispersées dans le cadre de scellement. Ces billes électriquement conductrices sont en contact d'une part avec les électrodes, et d'autre part avec des pistes conductrices qui courent sur le substrat arrière et qui permettent de prolonger ces électrodes hors de l'enceinte étanche délimitée par ledit cadre de scellement. Grâce à des connecteurs électriques, il est possible de relier les pistes conductrices, et par voie de conséquence les électrodes et les contre-électrodes du dispositif d'affichage à cristal liquide, au dispositif électronique externe d'alimentation et de commande.

Il existe de nos jours de nombreuses applications dans lesquelles un objet, notamment un objet portable, est équipé d'un dispositif d'affichage d'une information tel qu'un dispositif d'affichage à aiguille ou bien un dispositif d'affichage électrooptique, par exemple un dispositif d'affichage à cristal liquide du type succinctement décrit ci-dessus. Parmi les exemples qui viennent immédiatement à l'esprit, on peut citer les pièces d'horlogerie telles que les montres-bracelets ou bien encore les téléphones portables. De tels objets portables comprennent un cadre (encore appelé « carrure » dans le cas particulier des montres-bracelets) qui délimite une ouverture fermée par une glace. Cette glace comporte une surface supérieure dirigée du côté d'un observateur et une surface inférieure, opposée à la surface supérieure, dirigée du côté de l'intérieur de l'objet portable. Le dispositif d'affichage, par exemple à cristal liquide ou à aiguille, est destiné à afficher des informations qui vont être perceptibles par l'utilisateur à travers l'ouverture délimitée par le cadre de l'objet portable.

Il existe dans l'état de la technique des objets, en particulier des objets portables tels qu'une montre-bracelet ou un téléphone intelligent, qui comprennent un second dispositif d'affichage électrooptique disposé au-dessus du premier dispositif d'affichage. Un exemple d'un tel objet est une montre-bracelet qui comprend un dispositif d'affichage à cristal liquide nématique en hélice disposé au-dessus d'un second dispositif d'affichage électrooptique. Le substrat avant à travers lequel les informations affichées par le dispositif d'affichage à cristal liquide sont visibles présente une dimension égale ou sensiblement la même que celle de l'ouverture délimitée par la carrure de la montre-bracelet, tandis que le substrat arrière est de plus grande dimension que le substrat avant afin de procurer la surface suffisante pour pouvoir agencer tous les éléments nécessaires à la connexion électrique du dispositif d'affichage à cristal liquide à son dispositif électronique externe d'alimentation et de commande. La portion du substrat arrière qui excède les dimensions du substrat avant et qui est utilisée pour la fixation des éléments de connexion électrique s'étend sous la carrure de la montre-bracelet et est donc invisible au regard de l'utilisateur.

Dans ces modes de réalisation de l'art antérieur, la surface active du dispositif d'affichage électrooptique supérieur, c'est-à-dire l'étendue sur laquelle un tel dispositif d'affichage électrooptique peut afficher des informations, est sensiblement égale à l'étendue de l'ouverture délimitée par le cadre de l'objet. Ceci convient bien dans le cas d'un objet tel qu'une montre-bracelet qui comprend deux dispositifs d'affichage superposés de type électrooptique. En effet, le dispositif d'affichage électrooptique supérieur est agencé de façon que, lorsqu'il n'affiche pas d'informations, il est semi-transparent et laisse voir les informations affichées par le dispositif d'affichage électrooptique inférieur. Cette solution s'avère par contre bien moins adaptée dans le cas où le dispositif d'affichage inférieur n'est pas un dispositif d'affichage électrooptique. Tel est par exemple le cas si l'objet tel qu'une montre-bracelet est équipé, par exemple, d'un cadran au-dessus duquel se déplacent des aiguilles indicatrices. En effet, comme le dispositif d'affichage électrooptique qui est agencé au-dessus du dispositif d'affichage à aiguille est disposé entre deux polariseurs, moins de 50% de la lumière extérieure qui tombe sur ce dispositif d'affichage électrooptique va pénétrer à l'intérieur de la boîte de la montre, de sorte que le cadran et les aiguilles qui se déplacent au-dessus de celui-ci vont paraître sombres et seront difficilement perceptibles par l'utilisateur.

Il existe donc un besoin dans l'état de la technique pour un objet, en particulier un objet portable tel qu'une montre-bracelet ou un téléphone intelligent, comprenant un cadre qui délimite une ouverture à travers laquelle il soit possible de voir, non seulement les informations affichées par le dispositif d'affichage électrooptique, mais également les informations affichées par un second dispositif d'affichage agencé sous le dispositif d'affichage électrooptique, tout en masquant au regard de l'utilisateur les éléments de construction ainsi que les éléments de connexion électrique dont la vue nuirait à l'aspect esthétique de l'objet.

US2017/168463 A1 divulgue une montre comprenant un substrat pourvu d'un segment périphérique curviligne contigu à une pluralité de facettes, une zone d'affichage, une zone de bordure entourant la zone d'affichage, et des plages de connexion, divisées en groupes correspondant aux facettes, dans la zone de bordure.

### Résumé de l'invention

La présente invention a pour but de répondre aux besoins décrits ci-dessus ainsi qu'à d'autres encore en procurant un objet, en particulier un objet portable tel qu'une pièce d'horlogerie ou un téléphone intelligent, muni d'un premier dispositif d'affichage électrooptique et d'un second dispositif d'affichage agencé sous le dispositif d'affichage électrooptique, les informations affichées respectivement par le premier dispositif d'affichage électrooptique et par le second dispositif d'affichage étant perceptibles à travers l'ouverture délimitée par le cadre dont l'objet est équipé. En particulier, tous les éléments nécessaires à la connexion électrique du premier dispositif d'affichage électrooptique à son dispositif électronique externe d'alimentation et de commande doivent rester imperceptibles au regard de l'utilisateur.

A cet effet, la présente invention concerne un objet, en particulier un objet portable tel qu'une pièce d'horlogerie ou un téléphone intelligent, cet objet comprenant un dispositif d'affichage électrooptique muni d'un élément optiquement actif dont les propriétés optiques peuvent être modifiées par application d'un courant ou d'une tension électrique entre au moins une électrode et une contre-électrode correspondante entre lesquelles l'élément optiquement actif est disposé, l'objet comprenant également un cadre qui délimite une ouverture dans laquelle est agencé le dispositif d'affichage électrooptique, l'objet comprenant aussi un dispositif électronique externe d'alimentation et de commande ainsi que des éléments pour la connexion électrique du dispositif d'affichage électrooptique au dispositif électronique externe d'alimentation et de commande, le dispositif électronique externe d'alimentation et de commande, de même que les éléments de connexion électrique, étant masqués par le cadre de l'objet, le dispositif d'affichage électrooptique définissant une zone active d'affichage opaque dont la surface est inférieure à la surface de l'ouverture délimitée par le cadre, de sorte que, même lorsque le dispositif d'affichage électrooptique est activé et qu'il affiche des informations, il subsiste entre la zone active d'affichage et les bords du cadre une zone transparente, tandis qu'une zone située sous la zone active d'affichage est masquée.

Grâce à ces caractéristiques, la présente invention procure un objet, notamment un objet portable tel qu'une montre-bracelet ou un téléphone intelligent, muni d'un dispositif d'affichage électrooptique dont une zone active d'affichage opaque présente une surface qui est inférieure à celle de l'ouverture délimitée par le cadre de l'objet. Par conséquent, même lorsque la zone active d'affichage affiche des informations, il subsiste autour de cette zone active d'affichage et jusqu'au bord du cadre de l'objet, une zone transparente dépourvue de toute information affichée à travers laquelle on perçoit très distinctement ce qui est situé sous le dispositif d'affichage électrooptique. L'utilisateur a donc une vue directe et claire sur ce qui est situé sous la zone transparente. Inversement, la zone active d'affichage du dispositif d'affichage électrooptique étant opaque, on ne perçoit pas ce qui est situé sous cette zone active d'affichage. On obtient ainsi un objet, en particulier une montre-bracelet, que l'on peut qualifier de mystérieux étant donné que la zone active d'affichage du dispositif électrooptique est entourée par une zone transparente qui ne laisse rien voir du dispositif électronique externe d'alimentation et de commande ainsi que des éléments pour la connexion électrique du dispositif d'affichage électrooptique au dispositif électronique externe d'alimentation et de commande, de sorte que la zone active d'affichage semble n'être reliée à rien.

Selon un mode particulier de réalisation de l'invention, l'ouverture qui est délimitée par le cadre est fermée par le dispositif d'affichage électrooptique.

Selon un autre mode particulier de réalisation de l'invention, l'objet comprend une glace qui ferme l'ouverture et qui comprend une surface supérieure tournée du côté extérieur de l'objet, et une surface inférieure tournée du côté intérieur de l'objet et contre laquelle le dispositif d'affichage électrooptique est fixé.

Selon encore un autre mode particulier de réalisation de l'invention, le dispositif d'affichage électrooptique comprend un substrat avant transparent par lequel le dispositif d'affichage électrooptique est fixé contre la surface inférieure de la glace, le dispositif d'affichage électrooptique comprenant également un substrat arrière qui s'étend parallèlement à et à distance du substrat avant, les dimensions du substrat avant étant égales à ou sensiblement les mêmes que celles de la glace, tandis que les dimensions du substrat arrière excèdent celles de la glace afin de disposer d'une surface suffisante pour pouvoir agencer les éléments nécessaires à la connexion électrique du dispositif d'affichage électrooptique.

Selon encore un autre mode particulier de réalisation de l'invention, l'objet comprend un second dispositif d'affichage d'une information agencé sous le dispositif d'affichage électrooptique et au moins partiellement visible à travers la zone transparente.

Un exemple qui illustre bien les possibilités offertes par la présente invention est celui d'une montre-bracelet équipée d'un dispositif d'affichage électrooptique conformément à la présente invention et comprenant en outre un cadran muni d'aiguilles agencé sous le dispositif d'affichage électrooptique. Grâce aux caractéristiques de l'invention, l'utilisateur de la montre-bracelet voit ainsi simultanément à travers l'ouverture délimitée par la carrure de sa montre les informations digitales affichées par la zone active du dispositif d'affichage électrooptique, et les informations analogiques affichées par les aiguilles qui se déplacent au-dessus du cadran. Grâce à l'invention, on obtient donc une montre hybride munie d'un affichage du type « écran » et d'un affichage analogique dont l'aspect est original et innovant. On prendra cependant soin de bien noter que la présente invention n'est pas limitée à l'utilisation d'un dispositif d'affichage analogique disposé sous le dispositif d'affichage électrooptique, et que l'on peut très bien envisager de combiner un premier et un second dispositif d'affichage électrooptique entre eux, le second dispositif d'affichage électrooptique étant alors adapté pour afficher des informations dans des zones qui ne sont pas recouvertes par la zone active d'affichage du premier dispositif d'affichage électrooptique. On pourra ainsi au choix activer uniquement le premier dispositif d'affichage électrooptique fixé sous la glace, ou bien activer uniquement le second dispositif d'affichage électrooptique disposé sous le premier, ou bien activer les premier et second dispositifs d'affichage électrooptiques simultanément.

### Brève description des figures

D'autres caractéristiques et avantages de la présente invention ressortiront plus clairement de la description détaillée qui suit d'un exemple de réalisation d'un objet portable du type montre-bracelet selon l'invention, cet exemple étant donné à titre purement illustratif et non limitatif seulement en liaison avec le dessin annexé sur lequel :
- la figure 1 est une vue partielle en coupe d'une boîte de montre dont une carrure délimite une ouverture fermée par une glace contre la surface inférieure de laquelle est solidarisé un dispositif d'affichage électrooptique du type dispositif d'affichage à cristal liquide ;
- la figure 2 est une vue de dessus de la montre illustrée à la figure 1, et
- la figure 3 est une vue analogue à celle de la figure 1 dans le cas où le dispositif d'affichage électrooptique est un dispositif d'affichage à diodes organiques électroluminescentes OLED.

### Description détaillée d'un mode de réalisation de l'invention

La présente invention procède de l'idée générale inventive qui consiste à agencer un dispositif d'affichage électrooptique dans une ouverture délimitée par un cadre d'un objet, notamment un objet portable tel qu'une montre-bracelet ou un téléphone intelligent. L'originalité du dispositif d'affichage électrooptique est que ses dimensions sont les mêmes ou légèrement supérieures à celles de l'ouverture, mais que sa zone active d'affichage est opaque et présente une surface dont les dimensions sont inférieures à celles de l'ouverture. Par conséquent, même lorsque le dispositif d'affichage électrooptique est activé et qu'il affiche des informations, il subsiste entre sa zone active d'affichage et les bords du cadre de l'objet une zone transparente dépourvue de toute information affichée qui confère à l'objet un caractère mystérieux car ne permettant pas à l'utilisateur de deviner à quoi et comment le dispositif d'affichage électrooptique est relié pour les besoins de son alimentation et de sa commande. Selon un mode particulier de réalisation de l'invention, un second dispositif d'affichage d'une information agencé sous le dispositif d'affichage électrooptique est au moins partiellement visible à travers la zone transparente. Ce second dispositif d'affichage d'une information peut être de tout type : il peut s'agir simplement d'un motif décoratif; il peut également s'agir d'un second dispositif d'affichage électrooptique. Selon une variante préférée de réalisation de l'invention, le second dispositif d'affichage est un cadran au-dessus duquel se déplacent des aiguilles. Grâce à l'invention, on obtient donc une montre hybride munie d'un affichage du type « écran » et d'un affichage analogique dont l'aspect est original et innovant. En particulier, tous les éléments situés sous la zone transparente sont parfaitement visibles par l'utilisateur, tandis que les éléments qui se trouvent sous la zone active d'affichage sont imperceptibles

La présente invention va être décrite en liaison avec un objet portable du type montre-bracelet équipé d'un dispositif d'affichage électrooptique du type dispositif d'affichage à cristal liquide. Il va de soi que cet exemple est donné à titre purement illustratif et non limitatif seulement et que l'objet peut être autre chose qu'une pièce d'horlogerie. Il s'agit très généralement de tout type d'objet comme un téléphone ou un ordinateur portable comprenant un cadre qui délimite une ouverture à travers laquelle des informations affichées par le dispositif d'affichage électrooptique sont perceptibles. De même, le choix du dispositif d'affichage électrooptique n'est pas limité aux dispositifs d'affichage à cristal liquide et s'étend notamment aux dispositifs d'affichage du type à diodes organiques électroluminescentes ainsi qu'aux dispositifs d'affichage électrophorétiques et aux dispositifs d'affichage électrochromiques. En effet, ces différents types de dispositifs d'affichage électrooptiques comprennent tous au moins un substrat qui sert de support à un élément optiquement actif (cristal liquide par exemple nématique en hélice ou super nématique en hélice ou bien encore à alignement vertical pour un dispositif d'affichage à cristal liquide, couches actives d'injection de trous pour un dispositif d'affichage à diodes organiques électroluminescentes, particules noires et blanches ou particules couleurs dispersées dans un fluide dans le cas des dispositifs d'affichage électrophorétiques, électrolyte liquide ou solide dans le cas des dispositifs d'affichage électrochromiques), et des jeux d'électrodes et de contre-électrodes servant à modifier les propriétés optiques de l'élément optiquement actif par application d'une tension ou d'un courant électrique.

On notera qu'au sens de la présente invention, on entend par zone active d'affichage d'un dispositif d'affichage électrooptique la portion utile de la surface avant du dispositif d'affichage électrooptique sur laquelle des éléments d'information peuvent être affichés. A titre d'exemple, dans le cas d'un dispositif d'affichage électrooptique du type à cristal liquide nématique en hélice, on a affaire à deux substrats avant et arrière qui s'étendent parallèlement à et à distance l'un de l'autre et qui sont réunis entre eux par un cadre de scellement qui délimite une enceinte étanche pour le confinement du cristal liquide. Un film polariseur avant est fixé sur le dessus du substrat avant et sa direction de polarisation forme un angle de 90° avec la direction de polarisation d'un film polariseur arrière fixé sur le dessous du substrat arrière. On dit alors que les polariseurs sont croisés. Dans ce cas, les informations affichées par le dispositif d'affichage électrooptique dans sa zone active d'affichage vont apparaître en sombre sur un fond transparent. Pour que la zone active d'affichage apparaisse opaque, on peut combiner le film polariseur arrière avec un réflecteur ou bien prévoir un dispositif de rétroéclairage opaque sur le dessous du substrat arrière. En lieu et place du dispositif de rétroéclairage, un film opaque peut également convenir.

Il est également possible que les polariseurs soient parallèles, c'est-à-dire que leurs directions de polarisation soient parallèles entre elles. Un autre mode de réalisation encore consiste à combiner un polariseur circulaire fixé sur le dessus du substrat avant avec un réflecteur métallique agencé à l'intérieur du dispositif d'affichage à cristal liquide, sur le dessus du substrat arrière. La zone active d'affichage est donc définie comme le volume de cristal liquide compris entre le film polariseur avant et le film polariseur arrière ou entre le film polariseur circulaire et le réflecteur métallique.

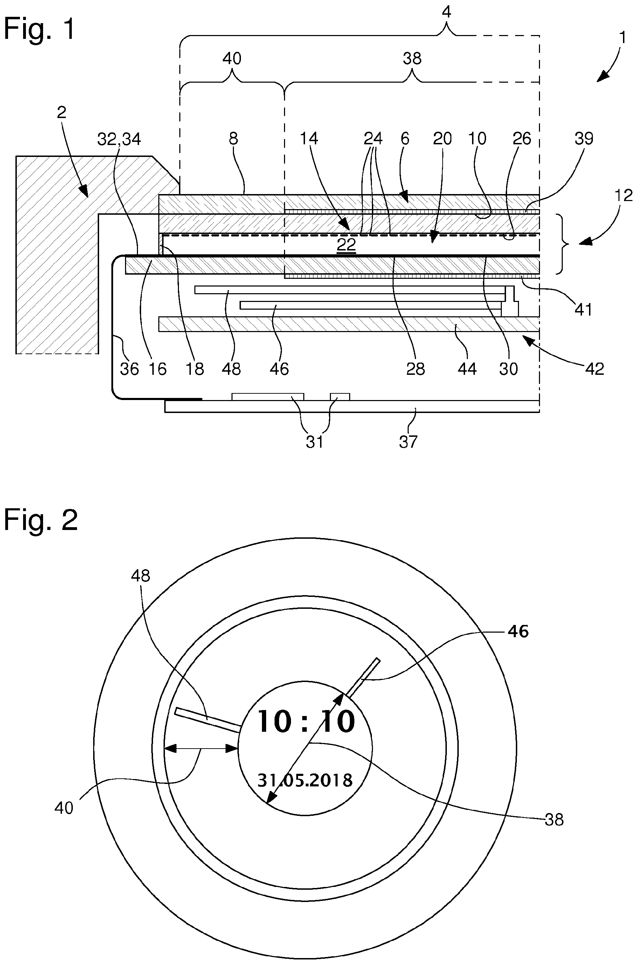

Désignée dans son ensemble par la référence numérique générale 1, la boîte de montre-bracelet représentée seulement en partie et en coupe sur la figure 1 comprend un cadre 2 que par la suite nous appellerons de préférence « carrure ». Cette carrure 2 délimite une ouverture 4, par exemple circulaire, qui est fermée de manière parfaitement étanche par une glace 6. Cette glace 6 comprend une surface supérieure 8 tournée du côté de l'utilisateur, et une surface inférieure 10, opposée à la surface supérieure 8 et tournée du côté de l'intérieur de la boîte 1 de montre-bracelet. Un dispositif d'affichage électrooptique, en l'occurrence un dispositif d'affichage à cristal liquide 12, comprend un substrat avant 14 transparent fixé par tout moyen approprié contre la surface inférieure 10 de la glace 6. Ce substrat avant 14 s'étend parallèlement à et à distance d'un substrat arrière 16 également transparent. Les substrats avant 14 et arrière 16 sont réunis entre eux au moyen d'un cadre de scellement 18 qui délimite une enceinte étanche 20 pour le confinement d'un cristal liquide 22. Le dispositif d'affichage à cristal liquide 12 est par exemple solidarisé par laminage au moyen d'une colle optiquement transparente (Optical Clear Adhesive ou OCA en terminologie anglo-saxonne) contre la surface inférieure 10 de la glace 6. La colle optiquement transparente a pour avantage d'éviter les problèmes de réflexions optiques parasites à l'interface entre la glace 6 et le dispositif d'affichage à cristal liquide 12. Des électrodes 24 réalisées en un matériau transparent électriquement conducteur tel que de l'oxyde d'étain-indium (Indium Tin Oxyde ou ITO en terminologie anglo-saxonne) sont structurées sur une face inférieure 26 du substrat avant 14 du dispositif d'affichage à cristal liquide 12, tandis que des contre-électrodes 28, elles aussi réalisées en un matériau transparent électriquement conducteur, sont structurées sur une face supérieure 30 du substrat arrière 16. Les électrodes 24 et les contre-électrodes 28 sont agencées de part et d'autre de la couche de cristal liquide 22. Par application d'une tension électrique appropriée entre une électrode et une contre-électrode données, on modifie les propriétés optiques du cristal liquide 22 au point de croisement entre l'électrode et la contre-électrode considérées.

Les dimensions du substrat avant 14 du dispositif d'affichage à cristal liquide 12 sont identiques ou supérieures à celles de l'ouverture 4 délimitée par la carrure 2. Quant au substrat arrière 16, ses dimensions sont plus grandes que celles du substrat avant 14 et il s'étend partiellement sous la carrure 2 de la montre-bracelet. Il faut en effet avoir présent à l'esprit que les électrodes 24 et les contre-électrodes 28 doivent être reliées à un dispositif électronique externe 31 d'alimentation et de commande. A cette fin, le substrat arrière 16 est prévu plus grand que le substrat avant 14 et l'on met à profit ce surcroît de surface pour prolonger par des premières pistes électriquement conductrices 32 réalisées en un matériau transparent électriquement conducteur tel que de l'oxyde d'étain-indium ou ITO les contre-électrodes 28 portées par le substrat arrière 16 hors du cadre de scellement 18 du dispositif d'affichage à cristal liquide 22. De même, les électrodes 24 portées par le substrat avant 14 sont reportées sur le substrat arrière 16 par exemple au moyen de billes conductrices de l'électricité et dispersées dans le cadre de scellement 18. Ces billes permettent de mettre en contact électrique les électrodes 24 avec des secondes pistes conductrices 34 également réalisées en un matériau transparent électriquement conducteur tel que de l'ITO et qui courent sur le substrat arrière 16, permettant de prolonger ces électrodes 24 hors de l'enceinte étanche délimitée par ledit cadre de scellement 18. Grâce à un circuit imprimé flexible 36, encore connu sous sa dénomination anglo-saxonne Flexible Printed Circuit ou FPC, il est possible de relier les pistes conductrices 32, 34 et, par voie de conséquence, les électrodes 24 et les contre-électrodes 28 du dispositif d'affichage à cristal liquide 12, au dispositif électronique externe 31 d'alimentation et de commande agencé sur une carte de circuit imprimé 37. Comme les premières et secondes pistes conductrices 32, 34 sont transparentes et que le circuit imprimé flexible 36 est masqué par la carrure 2 de la montre-bracelet, tous ces éléments sont invisibles au regard de l'utilisateur. De préférence, la carte de circuit imprimé 37 est disposée sous le dispositif d'affichage à cristal liquide 12.

Comme déjà indiqué ci-dessus, la zone active d'affichage 38 du dispositif d'affichage à cristal liquide 12 est définie par le volume du cristal liquide 22 confiné à l'intérieur du périmètre du cadre de scellement 18 et qui se trouve compris entre un polariseur supérieur 39 et un polariseur inférieur 41. Ces polariseurs 39, 41 peuvent être croisés, c'est-à-dire que leurs directions de polarisation forment un angle droit, ou bien parallèles, c'est-à-dire que leurs directions de polarisation s'étendent parallèlement entre elles. Conformément à l'invention, et comme cela ressort des figures 1 et 2 annexées à la présente demande de brevet, l'étendue de cette zone active d'affichage 38 est inférieure à la surface du substrat avant 14. Par conséquent, même lorsque le dispositif d'affichage à cristal liquide 12 est activé et qu'il affiche des informations, il subsiste entre sa zone active d'affichage 38 et les bords de la carrure 2 de la montre-bracelet une zone transparente 40 dépourvue de toute information affichée à travers laquelle il est possible de voir un second dispositif d'affichage 42 d'une information agencé sous le dispositif d'affichage à cristal liquide 12. Ce second dispositif d'affichage 42 d'une information peut être de tout type : il peut s'agir simplement d'un motif décoratif ; il peut également s'agir d'un second dispositif d'affichage électrooptique. Selon une variante préférée de réalisation de l'invention illustrée sur les figures 1 et 2, le second dispositif d'affichage 42 est formé d'un cadran 44 au-dessus duquel se déplacent des première et seconde aiguilles 46 et 48. Grâce à l'invention, on obtient donc une montre hybride munie d'un affichage du type « écran » et d'un affichage analogique dont l'aspect est original et innovant.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. En particulier, on aura compris que, au sens de la présente invention, l'ouverture délimitée par le cadre de l'objet, par exemple la carrure d'une montre-bracelet, peut être fermée soit directement par le dispositif d'affichage électrooptique, soit par une glace sur une face inférieure de laquelle est fixé le dispositif d'affichage à cristal liquide. Ainsi, comme décrit ci-dessus, le dispositif d'affichage à cristal liquide 12 peut être solidarisé contre la surface inférieure 10 de la glace 6 par l'intermédiaire de son substrat avant 14. Il peut néanmoins être également envisagé de s'affranchir de la glace 6 et de fermer l'ouverture 4 délimitée par le cadre 2 de l'objet portable directement au moyen du substrat avant 14 du dispositif d'affichage à cristal liquide 12.

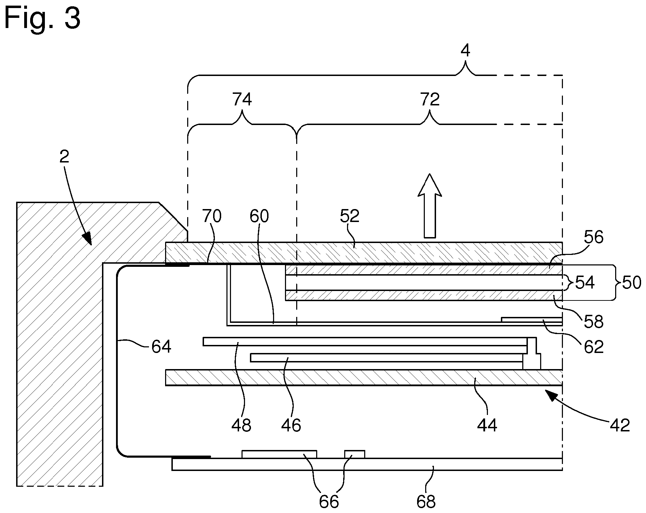

Selon une autre forme d'exécution de l'invention illustrée à la figure 3, on utilise un dispositif d'affichage à diodes organiques électroluminescentes OLED. Désigné dans son ensemble par la référence numérique générale 50, ce dispositif d'affichage OLED comprend un substrat avant 52 transparent qui sert de support à un empilement de couches organiques 54 pris en sandwich entre une anode 56 et une cathode 58. L'ensemble des couches du dispositif d'affichage OLED 50 est protégé de l'humidité à l'aide d'un couvercle 60 qui définit une enceinte étanche dans laquelle est agencé un dispositif absorbeur d'humidité 62. A titre de variante, l'ensemble des couches du dispositif d'affichage OLED 50 peut être protégé par dépôt de couches minces. Ces couches minces peuvent être déposées par dépôt de couches atomiques, technique mieux connue sous sa dénomination anglo-saxonne Atomic Layer Déposition ou ALD. Un circuit imprimé flexible 64 permet de relier le dispositif d'affichage OLED 50 à un dispositif électronique externe 66 d'alimentation et de commande agencé sur une carte de circuit imprimé 68 via des pistes conductrices 70 qui s'étendent hors de l'enceinte étanche délimitée par le couvercle 60. De préférence, la carte de circuit imprimé 68 est disposée sous le dispositif d'affichage OLED 50. La zone active d'affichage 72 du dispositif d'affichage OLED 50 est définie par la zone de recouvrement entre l'anode 56 et la cathode 58. Cette zone active d'affichage 72 a un aspect métallique en l'absence de polariseur circulaire, et aura un aspect sombre si l'on utilise un tel polariseur circulaire. Conformément à l'invention, et comme cela ressort de la figure 3, l'étendue de la zone active d'affichage 72 est inférieure à la surface de l'ouverture 4 délimitée par le cadre 2 de l'objet portable. Par conséquent, même lorsque le dispositif d'affichage OLED 50 est activé et qu'il affiche des informations, il subsiste entre sa zone active d'affichage 72 et les bords du cadre 2 de l'objet portable une zone transparente 74 dépourvue de toute information affichée à travers laquelle il est possible de voir un second dispositif d'affichage 42 tel qu'un cadran 44 au-dessus duquel se déplacent des première et seconde aiguilles 46, 48. Dans l'exemple représenté à la figure 3, le dispositif d'affichage OLED 50 est du type à émission par le bas (bottom émission en terminologie anglo-saxonne), c'est-à-dire que la lumière émerge du dispositif d'affichage OLED 50 à travers le substrat avant 52. Il est donc tout à fait envisageable de fermer l'ouverture 4 délimitée par le cadre 2 de l'objet portable au moyen du substrat avant 52. Bien entendu, il est également possible de fermer l'ouverture 4 au moyen d'une glace 6 et de solidariser le dispositif d'affichage OLED 50 contre la surface inférieure 10 de la glace 6 via son substrat avant 52. Dans le cas où le dispositif d'affichage OLED 50 est du type à émission par le haut (top emission en terminologie anglo-saxonne), c'est-à-dire dans le cas où la lumière émerge du dispositif d'affichage OLED du côté opposé au substrat avant 52, il peut être envisagé de fermer l'ouverture 4 délimitée par le cadre 2 de l'objet portable directement au moyen du couvercle 60 du dispositif d'affichage OLED 50, ou bien en solidarisant le couvercle 60 contre la surface inférieure 10 de la glace 6. Dans le cas où le dispositif d'affichage OLED 50 est protégé de l'humidité par dépôt de couches minces sur l'ensemble de ses couches, le dispositif d'affichage OLED 50 est fixé contre la surface inférieure 10 de la glace 6 par l'intermédiaire des couches minces.

### Nomenclature

1. Boîte de montre-bracelet
2. Cadre
4. Ouverture
6. Glace
8. Surface supérieure
10. Surface inférieure
12. Dispositif d'affichage à cristal liquide
14. Substrat avant
16. Substrat arrière
18. Cadre de scellement
20. Enceinte étanche
22. Cristal liquide
24. Electrodes
26. Face inférieure
28. Contre-électrodes
30. Face supérieure
31. Dispositif électronique externe d'alimentation et de commande
32. Premières pistes électriquement conductrices
34. Secondes pistes électriquement conductrices
36. Circuit imprimé flexible
37. Carte de circuit imprimé
38. Zone active d'affichage
39. Polariseur supérieur
40. Zone transparente
41. Polariseur inférieur
42. Second dispositif d'affichage
44. Cadran
46, 48. Première et seconde aiguille
50. Dispositif d'affichage à diodes organiques électroluminescentes OLED
52. Substrat avant
54. Empilement de couches organiques
56. Anode
58. Cathode
60. Couvercle
62. Dispositif absorbeur d'humidité
64. Circuit imprimé flexible
66. Dispositif électronique externe d'alimentation et de commande
68. Carte de circuit imprimé
70. Pistes conductrices
72. Zone active d'affichage
74. Zone transparente

## Revendications

1. Objet, en particulier un objet portable tel qu'une pièce d'horlogerie ou un téléphone intelligent, cet objet comprenant un dispositif d'affichage électrooptique muni d'un élément optiquement actif dont les propriétés optiques peuvent être modifiées par application d'un courant ou d'une tension électrique entre au moins une électrode et une contre-électrode correspondante entre lesquelles l'élément optiquement actif est disposé, l'objet comprenant également un cadre (2) qui délimite une ouverture (4) dans laquelle est agencé le dispositif d'affichage électrooptique, l'objet comprenant aussi un dispositif électronique externe (31 ; 66) d'alimentation et de commande ainsi que des éléments (32, 34, 36 ; 64, 70) pour la connexion électrique du dispositif d'affichage électrooptique au dispositif électronique externe (31 ; 66) d'alimentation et de commande, le dispositif électronique externe (31 ; 66) d'alimentation et de commande, de même que les éléments de connexion électrique (32, 34, 36 ; 64, 70), étant masqués par le cadre (2) de l'objet, **caractérisé en ce que** le dispositif d'affichage électrooptique définit une zone active d'affichage (38 ; 72) opaque dont la surface est inférieure à la surface de l'ouverture (4) délimitée par le cadre (2), de sorte que, même lorsque le dispositif d'affichage électrooptique est activé et qu'il affiche des informations, il subsiste entre la zone active d'affichage (38 ; 72) et les bords du cadre (2) une zone transparente (40 ; 74), tandis qu'une zone située sous la zone active d'affichage (38 ; 72) est masquée.

2. Objet selon la revendication 1, **caractérisé en ce que** l'ouverture (4) délimitée par le cadre (2) est fermée par le dispositif d'affichage électrooptique.

3. Objet selon la revendication 1, **caractérisé en ce qu'**il comprend une glace (6) qui ferme l'ouverture (4) et qui comprend une surface supérieure (8) tournée du côté extérieur de l'objet, et une surface inférieure (10) tournée du côté intérieur de l'objet et contre laquelle le dispositif d'affichage électrooptique est fixé.

4. Objet selon la revendication 2, **caractérisé en ce que** le dispositif d'affichage électrooptique comprend au moins un substrat avant (14 ; 52) transparent par lequel le dispositif d'affichage électrooptique ferme l'ouverture (4) délimitée par le cadre (2), le substrat avant (14 ; 52) transparent servant de support à l'élément optiquement actif qui est disposé entre au moins une électrode et une contre-électrode correspondante et dont les propriétés optiques sont modifiées par application d'une tension ou d'un courant entre l'électrode et la contre électrode correspondante.

5. Objet selon la revendication 3, **caractérisé en ce que** le dispositif d'affichage électrooptique comprend au moins un substrat avant (14 ; 52) transparent par lequel le dispositif d'affichage électrooptique est fixé contre la surface inférieure (10) de la glace (6), le substrat avant (14 ; 52) transparent servant de support à l'élément optiquement actif qui est disposé entre au moins une électrode et une contre-électrode correspondante et dont les propriétés optiques sont modifiées par application d'une tension ou d'un courant entre l'électrode et la contre électrode correspondante.

6. Objet selon l'une des revendications 4 et 5, **caractérisé en ce que** le dispositif d'affichage électrooptique comprend également un substrat arrière (16) transparent qui s'étend parallèlement à et à distance du substrat avant (14), les dimensions du substrat avant (14) étant égales à ou supérieures à celles de l'ouverture (4) délimitée par le cadre (2), tandis que les dimensions du substrat arrière (16) excèdent celles du substrat avant (14) afin de disposer d'une surface suffisante pour pouvoir agencer les éléments (32, 34, 36) nécessaires à la connexion électrique du dispositif d'affichage électrooptique au dispositif électronique externe (31) d'alimentation et de commande.

7. Objet selon la revendication 6, **caractérisé en ce que** le dispositif d'affichage électrooptique est un dispositif d'affichage à cristal liquide (12), et **en ce que** les substrats avant (14) et arrière (16) sont réunis entre eux au moyen d'un cadre de scellement (18) qui délimite une enceinte étanche (20) pour le confinement d'un cristal liquide (22), un volume de cristal liquide (22) compris entre un polariseur supérieur (39) et un polariseur inférieur (41) ou entre un polariseur et un réflecteur métallique définissant la zone active d'affichage (38) du dispositif d'affichage à cristal liquide (12).

8. Objet selon la revendication 7, **caractérisé en ce qu'**il comprend un circuit imprimé flexible (36) qui permet de relier le dispositif d'affichage à cristal liquide (12) au dispositif électronique externe (31) d'alimentation et de commande via des pistes électriquement conductrices (32, 34) qui s'étendent hors de l'enceinte étanche (20) délimitée par le cadre de scellement (18).

9. Objet selon l'une des revendications 4 et 5, **caractérisé en ce que** le dispositif d'affichage électrooptique est un dispositif d'affichage OLED (50) dont le substrat avant (52) transparent sert de support à un empilement de couches organiques (54) pris en sandwich entre une anode (56) et une cathode (58), le dispositif d'affichage OLED (50) étant protégé de l'humidité à l'aide d'un couvercle (60) qui définit une enceinte étanche dans laquelle est agencé un dispositif absorbeur d'humidité (62), ou bien par dépôt de couches minces sur l'empilement formé par l'anode (56) et la cathode (58) entre lesquelles s'étend l'empilement de couches organiques (54).

10. Objet selon la revendication 9, **caractérisé en ce que** la zone active d'affichage (72) du dispositif d'affichage OLED (50) est définie par la zone de recouvrement entre l'anode (56) et la cathode (58).

11. Objet selon l'une des revendications 9 et 10, **caractérisé en ce qu'**il comprend un circuit imprimé flexible (64) qui permet de relier le dispositif d'affichage OLED (50) à un dispositif électronique externe (66) d'alimentation et de commande via des pistes conductrices (70) qui s'étendent hors de l'enceinte étanche délimitée par le couvercle (60) ou par les couches minces.

12. Objet selon l'une des revendications 1 à 11, **caractérisé en ce qu'**il comprend un second dispositif d'affichage (42) d'une information agencé sous le dispositif d'affichage électrooptique et au moins partiellement visible à travers la zone transparente (40).

13. Objet selon la revendication 12, **caractérisé en ce que** le dispositif électronique externe (31 ; 66) d'alimentation et de commande est disposé sous le second dispositif d'affichage (42).

14. Objet selon l'une des revendications 1 à 12, **caractérisé en ce que** le dispositif électronique externe (31 ; 66) d'alimentation et de commande est disposé sous le dispositif d'affichage électrooptique.

## Patentansprüche

1. Gegenstand, vor allem ein tragbarer Gegenstand wie eine Uhr oder ein intelligentes Telefon, wobei dieser Gegenstand eine elektrooptische Anzeigevorrichtung umfasst, die mit einem optisch aktiven Element versehen ist, dessen optische Eigenschaften durch Anwendung eines Stroms oder einer elektrischen Spannung zwischen mindestens einer Elektrode und einer entsprechenden Gegenelektrode, zwischen denen das optisch aktive Element angeordnet ist, veränderbar sind, wobei der Gegenstand ebenfalls einen Rahmen (2) umfasst, der eine Öffnung (4) begrenzt, in welcher die elektrooptische Anzeigevorrichtung eingerichtet ist, wobei der Gegenstand auch eine äußere elektronische Versorgungs- und Steuervorrichtung (31; 66) sowie Elemente (32, 34, 36; 64, 70) für die elektrische Verbindung der elektrooptischen Anzeigevorrichtung mit der äußeren elektronischen Versorgungs- und Steuervorrichtung (31; 66) umfasst, wobei die äußere elektronische Versorgungs- und Steuervorrichtung (31; 66), gleichermaßen wie die elektrischen Verbindungselemente (32, 34, 36; 64, 70), von dem Rahmen (2) des Gegenstands maskiert sind, **dadurch gekennzeichnet, dass** die elektrooptische Anzeigevorrichtung eine lichtdichte aktive Anzeigezone (38; 72) definiert, deren Fläche kleiner als die Fläche der von dem Rahmen (2) begrenzten Öffnung (4) ist, so dass, selbst wenn die elektrooptische Anzeigevorrichtung aktiviert ist und sie Informationen anzeigt, zwischen der aktiven Anzeigezone (38; 72) und den Rändern des Rahmens (2) eine durchsichtige Zone (40; 74) verbleibt, wohingegen eine Zone, die sich unter der aktiven Anzeigezone (38; 72) befindet, maskiert ist.

2. Gegenstand nach Anspruch 1, **dadurch gekennzeichnet, dass** die von dem Rahmen (2) begrenzte Öffnung (4) von der elektrooptischen Anzeigevorrichtung verschlossen ist.

3. Gegenstand nach Anspruch 1, **dadurch gekennzeichnet, dass** er ein Glas (6) umfasst, welches die Öffnung (4) verschließt und das eine obere Fläche (8) umfasst, die zur Außenseite des Gegenstands zeigt, und eine innere Fläche (10), die zur Innenseite des Gegenstands zeigt und an der die elektrooptische Anzeigevorrichtung befestigt ist.

4. Gegenstand nach Anspruch 2, **dadurch gekennzeichnet, dass** die elektrooptische Anzeigevorrichtung mindestens ein durchsichtiges vorderes Substrat (14; 52) umfasst, mit dem die elektrooptische Anzeigevorrichtung die von dem Rahmen (2) begrenzte Öffnung (4) verschließt, wobei das durchsichtige vordere Substrat (14; 52) als Träger für das optisch aktive Element dient, das zwischen mindestens einer Elektrode und einer entsprechenden Gegenelektrode angeordnet ist und dessen optische Eigenschaften durch Anlegen einer Spannung oder eines Stroms zwischen der Elektrode und der entsprechenden Gegenelektrode verändert werden.

5. Gegenstand nach Anspruch 3, **dadurch gekennzeichnet, dass** die elektrooptische Anzeigevorrichtung mindestens ein durchsichtiges vorderes Substrat (14; 52) umfasst, durch das die elektrooptische Anzeigevorrichtung an der unteren Fläche (10) des Glases (6) befestigt ist, wobei das durchsichtige vordere Substrat (14; 52) als Träger für das optisch aktive Element dient, das zwischen mindestens einer Elektrode und einer entsprechenden Gegenelektrode angeordnet ist und dessen optische Eigenschaften durch Anlegen einer Spannung oder eines Stroms zwischen der Elektrode und der entsprechenden Gegenelektrode verändert werden.

6. Gegenstand nach einem der Ansprüche 4 und 5, **dadurch gekennzeichnet, dass** die elektrooptische Anzeigevorrichtung ebenfalls ein durchsichtiges hinteres Substrat (16) umfasst, das sich parallel zu und von dem vorderen Substrat (14) beabstandet erstreckt, wobei die Abmessungen des vorderen Substrats (14) gleich denen oder größer als die von dem Rahmen (2) begrenzten Öffnung (4) sind, wohingegen die Abmessungen des hinteren Substrats (16) die des vorderen Substrats (14) überschreiten, um über eine Fläche zu verfügen, die ausreichend ist, um die für die elektrische Verbindung der elektrooptischen Anzeigevorrichtung mit der äußeren Versorgungs- und Steuervorrichtung (31) notwendigen Elemente (32, 34, 36) einrichten zu können.

7. Gegenstand nach Anspruch 6, **dadurch gekennzeichnet, dass** die elektrooptische Anzeigevorrichtung eine Flüssigkeitskristallanzeigevorrichtung (12) ist und dass das vordere (14) und hintere (16) Substrat mittels eines Verschlussrahmens (18) miteinander vereint sind, der ein dichtes Behältnis (20) für den Einschluss eines Flüssigkeitskristalls (22) begrenzt, wobei ein Flüssigkeitskristallvolumen (22) zwischen einem oberen Polarisierer (39) und einem unteren Polarisierer (41) oder zwischen einem Polarisierer und einem Metallreflektor die aktive Anzeigezone (38) der Flüssigkeitskristallanzeigevorrichtung (12) definiert.

8. Gegenstand nach Anspruch 7, **dadurch gekennzeichnet, dass** er einen flexiblen gedruckten Schaltkreis (36) umfasst, der erlaubt, die Flüssigkeitskristallanzeigevorrichtung (12) mit der äußeren elektronischen Versorgungs- und Steuervorrichtung (31) über elektrische Leiterbahnen (32, 34) zu verbinden, die sich außerhalb des von dem Verschlussrahmen (18) begrenzten dichten Behältnisses (20) erstrecken.

9. Gegenstand nach einem der Ansprüche 4 und 5, **dadurch gekennzeichnet, dass** die elektrooptische Anzeigevorrichtung eine OLED-Anzeigevorrichtung (50) ist, deren durchsichtiges vorderes Substrat (52) als Träger für einen Stapel organischer Schichten (54) dient, die sandwichartig zwischen einer Anode (56) und einer Kathode (58) eingeschlossen sind, wobei die OLED-Anzeigevorrichtung (50) mit Hilfe eines Deckels (60) gegen Feuchtigkeit geschützt ist, der ein dichtes Behältnis definiert, in dem eine feuchtigkeitsabsorbierende Vorrichtung (62) eingerichtet ist, oder auch durch Aufbringen dünner Schichten auf den von der Anode (56) und der Kathode (58) gebildeten Stapel, zwischen denen sich der Stapel organischer Schichten (54) erstreckt.

10. Gegenstand nach Anspruch 9, **dadurch gekennzeichnet, dass** die aktive Anzeigezone (72) der OLED-Anzeigevorrichtung (50) durch die Überlappungszone zwischen der Anode (56) und der Kathode (58) definiert ist.

11. Gegenstand nach einem der Ansprüche 9 und 10, **dadurch gekennzeichnet, dass** er einen flexiblen gedruckten Schaltkreis (64) umfasst, der erlaubt, die OLED-Anzeigevorrichtung (50) mit einer äußeren elektronischen Versorgungs- und Steuervorrichtung (66) über Leiterbahnen (70) zu versorgen, die sich außerhalb des dichten Behältnisses erstrecken, der von dem Deckel (60) oder von den Dünnschichten begrenzt ist.

12. Gegenstand nach einem der Ansprüche 1 bis 11, **dadurch gekennzeichnet, dass** er eine zweite Anzeigevorrichtung (42) einer Information umfasst, die unter der elektrooptischen Anzeigevorrichtung angeordnet und mindestens teilweise durch die durchsichtige Zone (40) sichtbar ist.

13. Gegenstand nach Anspruch 12, **dadurch gekennzeichnet, dass** die äußere elektronische Versorgungs- und Steuervorrichtung (31; 66) unter der zweiten Anzeigevorrichtung (42) angeordnet ist.

14. Gegenstand nach einem der Ansprüche 1 bis 12, **dadurch gekennzeichnet, dass** die äußere elektronische Versorgungs- und Steuervorrichtung (31; 66) unter der elektrooptischen Anzeigevorrichtung angeordnet ist.

## Claims

1. Object, in particular a portable object such as a timepiece or smartphone, this object comprising an electro-optic display device provided with an optically active element, whose optical properties can be modified by applying an electric voltage or current between at least one electrode and one corresponding auxiliary electrode, between which the optically active element is disposed, the object further comprising a frame (2) which delimits an opening (4) wherein the electro-optic display device is arranged, the object further comprising an external electronic power and control device (31; 66) in addition to elements (32, 34, 36; 64, 70) for the electrical connection of the electro-optic display device to the external electronic power and control device (31; 66), the external electronic power and control device (31; 66), as well as the electrical connection elements (32, 34, 36; 64, 70) being hidden by the frame (2) of the object, **characterized in that** the electro-optic display device defines an opaque active display area (38; 72), whose surface area is less than the surface area of the opening (4) delimited by the frame (2), such that, even when the electro-optic display device is activated and displays information, a transparent area (40; 74) remains between the active display area (38; 72) and the edges of the frame (2), whereas an area located beneath the active display area (38; 72) is hidden.

2. Object according to claim 1, **characterised in that** the opening (4) delimited by the frame (2) is closed by the electro-optic display device.

3. Object according to claim 1, **characterised in that** it comprises a crystal (6) that closes the opening (4) and that comprises a top surface (8) directed towards the exterior of the object, and a bottom surface (10) directed towards the interior of the object and to which the electro-optic display device is attached.

4. Object according to claim 2, **characterised in that** the electro-optic display device comprises at least one transparent front substrate (14; 52) via which the electro-optic display device closes the opening (4) delimited by the frame (2), the transparent front substrate (14; 52) acting as a support for the optically active element which is disposed between at least one electrode and one corresponding auxiliary electrode, the optical properties thereof being modified by applying a voltage or a current between the electrode and the corresponding auxiliary electrode.

5. Object according to claim 3, **characterised in that** the electro-optic display device comprises at least one transparent front substrate (14; 52) via which the electro-optic display device is attached to the bottom surface (10) of the crystal (6), the transparent front substrate (14; 52) acting as a support for the optically active element which is disposed between at least one electrode and one corresponding auxiliary electrode, and the optical properties thereof being modified by applying a voltage or a current between the electrode and the corresponding auxiliary electrode.

6. Object according to one of claims 4 and 5, **characterised in that** the electro-optic display device further comprises a transparent rear substrate (16) that extends parallel to and remotely from the front substrate (14), the dimensions of the front substrate (14) being equal to or greater than those of the opening (4) delimited by the frame (2), whereas the dimensions of the rear substrate (16) exceed those of the front substrate (14) in order to have a sufficient surface area for arranging the elements (32, 34, 36) required for the electrical connection of the electro-optic display device to the external electronic power and control device (31).

7. Object according to claim 6, **characterised in that** the electro-optic display device is a liquid crystal display device (12), and **in that** the front substrate (14) and the rear substrate (16) are joined to one another by means of a sealing frame (18) which delimits a sealed enclosure (20) for confining a liquid crystal (22), a volume of liquid crystal (22) comprised between an upper polariser (39) and a lower polariser (41) or between a polariser and a metal reflector defining the active display area (38) of the liquid crystal display device (12).

8. Object according to claim 7, **characterised in that** it comprises a flexible printed circuit (36) which allows the liquid crystal display device (12) to be connected to the external electronic power and control device (31) via electrically-conductive tracks (32, 34) which extend outside of the sealed enclosure (20) delimited by the sealing frame (18).

9. Object according to one of claims 4 and 5, **characterised in that** the electro-optic display device is an OLED display device (50), the transparent front substrate (52) thereof acting as a support for a stack of organic layers (54) sandwiched between an anode (56) and a cathode (58), the OLED display device (50) being protected from humidity by a cover (60) which defines a sealed enclosure wherein a humidity-absorbing device (62) is arranged, or by the deposition of thin films on the stack formed by the anode (56) and the cathode (58) between which extends the stack of organic layers (54).

10. Object according to claim 9, **characterised in that** the active display area (72) of the OLED display device (50) is defined by the overlap area between the anode (56) and the cathode (58).

11. Object according to one of claims 9 and 10, **characterised in that** it comprises a flexible printed circuit (64) which allows the OLED display device (50) to be connected to an external electronic power and control device (66) via conductive tracks (70) which extend outside of the sealed enclosure delimited by the cover (60) or by the thin films.

12. Object according to one of claims 1 to 11, **characterised in that** it comprises a second device (42) for displaying information arranged beneath the electro-optic display device and at least partially visible through the transparent area (40).

13. Object according to claim 12, **characterised in that** the external electronic power and control device (31; 66) is disposed beneath the second display device (42).

14. Object according to one of claims 1 to 12, **characterised in that** the external electronic power and control device (31; 66) is disposed beneath the electro-optic display device.
